# FASCICULE DE BREVET EUROPEEN

(11) **EP 0 453 369 B1**
(45) Date de publication et mention de la délivrance du brevet: **14.09.1994**
(21) Numéro de dépôt: 91401033.5
(22) Date de dépôt: 18.04.1991
(51) Int. Cl.: H05K 13/04, H05K 13/08

(54) **Dispositif et procédé de montage automatique de composants électroniques**
Einrichtung und Verfahren zum automatischen Bestücken von elektronischen Bauelementen
Apparatus and process for the automatic mounting of electronic components

(30) Priorité: 20.04.1990 FR 9005076
(43) Date de publication de la demande: 23.10.1991
(73) Titulaire: EUROPLACER INDUSTRIES, F-85620 Rocheservière (FR)
(72) Inventeur: Chataigner Gabriel, F-85620 Rocheserviere (FR); Mouette, Didier, F-44000 Nantes (FR)
(74) Mandataire: Fort, Jacques

(56) Documents cités:
- EP-A- 0 065 604
- EP-A- 0 315 799
- GB-A- 2 173 426

## Description

L'invention concerne de façon générale le montage automatique de composants électroniques, notamment de composants électroniques à fixer à plat, sur un substrat qui est généralement constitué par un circuit imprimé.

On connaît déjà de nombreuses machines destinées à remplir cette fonction. On peut citer, à titre d'exemple, les machines décrites dans les documents GB-A-2 173 426 et EP-A-0 065 604. La machine décrite dans le premier document comprend un bâti définissant une voie de circulation longitudinale et un support déplaçable le long de la voie et portant une tête de montage de chaque côté de la voie. Cette tête est prévue pour venir prendre des composants à la sortie de magasins d'alimentation placés, dans le sens longitudinal, de part et d'autre d'une table à déplacements croisés sur laquelle on pose les substrats successifs à équiper de composants.

Cette disposition présente un certain nombre d'inconvénients. L'accès de l'opérateur aux différents emplacements où il risque de se produire des incidents est gêné, du fait que les deux côtés de la voie sont encombrés par les magasins et la table à déplacements croisés. Les cinématiques de mouvement sont complexes et diminuent la cadence.

La présente invention vise à fournir un procédé et un dispositif de montage automatique répondant mieux que ceux antérieurement connus aux exigences de la pratique, notamment en facilitant le réapprovisionnement de la machine en composants, en facilitant l'intervention de l'opérateur à partir d'une des faces de la machine et en simplifiant la cinématique.

Dans ce but l'invention propose notamment une machine automatique de montage de composants électroniques sur des substrats successifs, comprenant, en combinaison, un convoyeur d'approvisionnement en substrats successifs suivant une direction longitudinale X vers un emplacement accessible par une table munie de moyens permettant de la déplacer transversalement suivant une direction Y, un convoyeur d'évacuation de substrats suivant la direction longitudinale X à partir de la table, au moins une tête déplaçable dans le direction longitudinale pour venir se placer face à des magasins d'approvisionnement en composants répartis dans la direction longitudinale du bâti, d'un seul côté de ce dernier, et munie de moyens d'identification des composants et de moyens permettant de prélever un composant à la fois et de le poser sur le substrat, et des moyens de calcul et de commande des déplacements des convoyeurs, de la table et de la tête suivant un programme pré-enregistré.

Dans un mode avantageux de réalisation, deux têtes sont prévues, la plage de déplacement longitudinale de chaque tête n'étant limitée que par la position prise à un instant donné par l'autre. La machine comportera en règle générale des moyens de pré-encollage du substrat aux emplacements destinés à recevoir les composants : ces moyens peuvent être constitués par une unité d'encollage portant un micro-doseur de colle, pouvant se déplacer entre une position d'attente, à une extrémité de la machine dans la direction longitudinale, et une position située au-dessus de la table. Une solution avantageuse consiste à prévoir l'unité d'encollage de façon quelle puisse être accouplée à une tête de prélèvement et de pose de composants.

Lorsque deux têtes sont prévues, les moyens de calcul et de commande leur donnent un fonctionnement autonome, si ce n'est que le programme peut être prévu pour que les composants contenus dans un magasin situé à un emplacement inaccessible par une tête soient mis en place par l'autre.

L'invention propose également un procédé de montage automatique de composants sur des substrats successifs, suivant lequel on amène chaque substrat à son tour sur une table de déplacement suivant une direction Y, on dépose une quantité dosée de colle à l'emplacement destiné à recevoir un composant et on place ce dernier à l'aide d'une tête de prélèvement, de déplacement suivant une direction X longitudinale orthogonale à Y, et de dépose, de manière qu'on identifie chaque magasin au passage de la tête devant lui, on prélève le composant approprié dans le magasin identifié comme le contenant à l'aide de la tête, on déplace la tête uniquement suivant ladite direction orthogonale X jusqu'à l'emplacement en X qui doit recevoir le composant, on déplace la table suivant Y jusqu'à ce que l'emplacement soit sous la tête et on pose le composant, toutes les opérations étant commandées en séquence par un programme pré-enregistré.

Le programme est avantageusement prévu, dans le cas où le procédé met en oeuvre deux têtes à déplacement colinéaire, pour que chaque tête de préhension soit autonome vis-à-vis de l'autre tête et comprenne ses moyens de déplacement, de repérage de magasin à composants, de préhension et d'identification des composants et de constat de la pose de ceux-ci.

Il peut également être prévu pour que, si un composant normalement affecté à la zone de préhension d'une première tête est situé dans la zone de préhension d'une deuxième tête, le cycle des opérations continue, le composant étant recherché, identifié et mis en place par la deuxième tête.

Le programme peut être prévu pour que, après recherche et identification des magasins et détermination des coordonnées exactes de préhension des composants suivant un plan horizontal, ainsi que des coordonnées exactes suivant le plan horizontal et de l'altitude du point de pose des composants les différentes coordonnées affectées à un composant soient mémorisées ; les coordonnées peuvent être corrigées d'un signal d'erreur délivré par les moyens d'identification du composant en fonction de la position réelle des composants sur la tête de préhension.

L'invention sera mieux comprise à la lecture de la description qui suit d'une machine qui en constitue un mode particulier de réalisation, donné à titre d'exemple non limitatif. La description se réfère aux dessins qui l'accompagnent, dans lesquels :
- la figure 1 est un schéma de principe montrant la répartition des composants principaux d'une machine suivant l'invention, représentée en vue de dessus ;
- la figure 2 montre schématiquement les composants principaux d'une tête de préhension utilisable sur une machine ayant la constitution générale indiquée en figure 1 ;
- la figure 3 est une vue de droite de la figure 2 ;
- la figure 4 montre une réalisation possible d'une machine selon le schéma de la figure 1 ;
- la figure 5 montre, en perspective, un chariot pouvant porter plusieurs magasins et utilisable en association avec la machine de la figure 4.

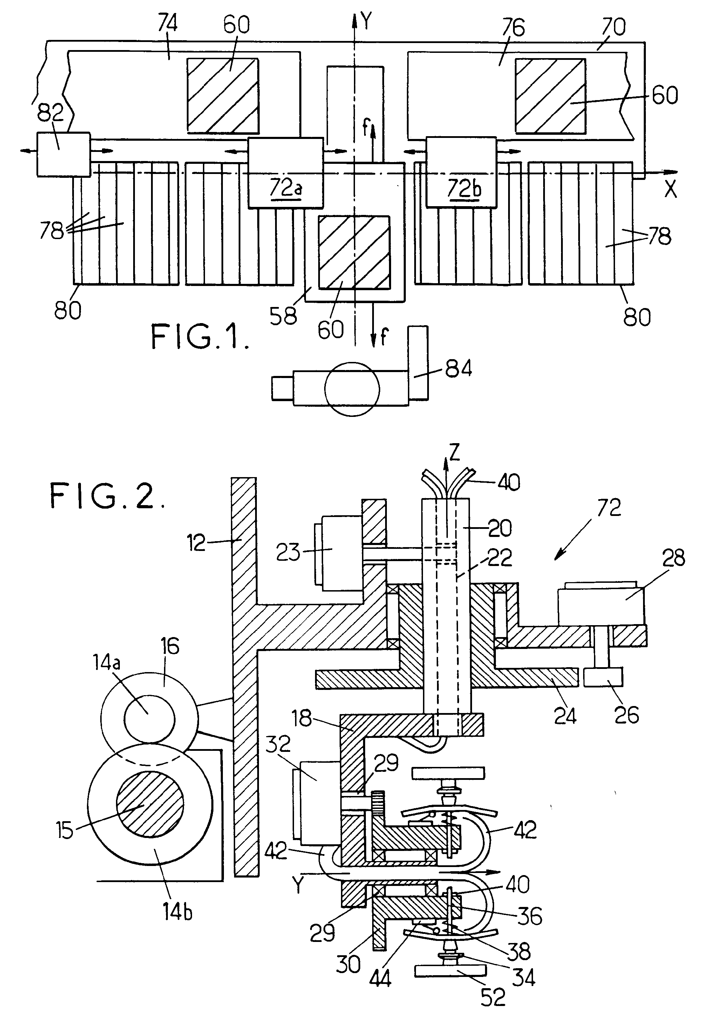

La machine de montage automatique dont le schéma de principe est montré en figure 1 peut être regardée comme comprenant un bâti fixe 70 muni de moyens définissant une voie de circulation longitudinale (dans la direction X). Sur cette voie de circulation peut se déplacer longitudinalement au moins une tête de saisie et de pose de composants. Dans le mode de réalisation illustré, deux têtes 72a et 72b se déplacent, indépendamment l'une de l'autre, le long de la voie de circulation.

Le bâti porte un convoyeur d'amenée de cartes 74 permettant de prendre une carte de circuits imprimés 60 à une extrémité du bâti et de l'amener à un emplacement accessible par une table 58 à laquelle des moyens non représentés permettent de donner une position réglable dans la direction tranversale (direction Y), comme indiqué par les flèches f. Un convoyeur d'évacuation 76 permet de reprendre une carte portée par la table 58, une fois que la carte a été équipée, et de l'évacuer longitudinalement à l'opposé du convoyeur 74.

Des magasins 78 d'alimentation en composants sont prévus pour être placés contre le bâti 70 de la machine, face au trajet parcouru par la tête (ou les têtes) de saisie et de pose. Chaque magasin, qui peut être de l'un quelconque des types actuellement connus et utilisés, contenant des composants successifs, tous identiques, est prévu pour amener ces composants successivement en un emplacement déterminé du magasin, accessible par la tête ou les têtes. Ces magasins peuvent être constitués par des distributeurs de composants stockés sur bande souple, des chargeurs contenant des composants empilés, etc... Il est avantageux de répartir les magasins de part et d'autre de la table 58, dans le sens longitudinal, en tenant compte des opérations que doivent effectuer les têtes 72a et 72b lorsque deux têtes sont prévues. Les magasins 78 sont avantageusement placés sur des chariots 80 facilitant leur amenée et leur enlèvement, les magasins étant individuellement remplaçables sur les chariots.

Dans de nombreux cas, les composants à mettre en place doivent être retenus par collage sur la carte de circuits imprimés. Pour cela, une quantité faible et reproductible de colle doit être déposée à l'emplacement convenable sur la carte avant mise en place du composant. La machine montrée schématiquement en figure 1 comprend une unité de pré-encollage 82 déplaçable le long de la voie de circulation longitudinale. Cette unité peut comporter un micro-doseur de constitution générale connue et être prévue pour s'accrocher, en cas de besoin, à la tête ou une des têtes pour être entraînée par cette dernière.

Le micro-doseur est par exemple du type décrit dans le document WO 90/00852.

La tête ou chaque tête de saisie et de pose ne sera que sommairement décrite, en faisant référence aux figures 2 à 3.

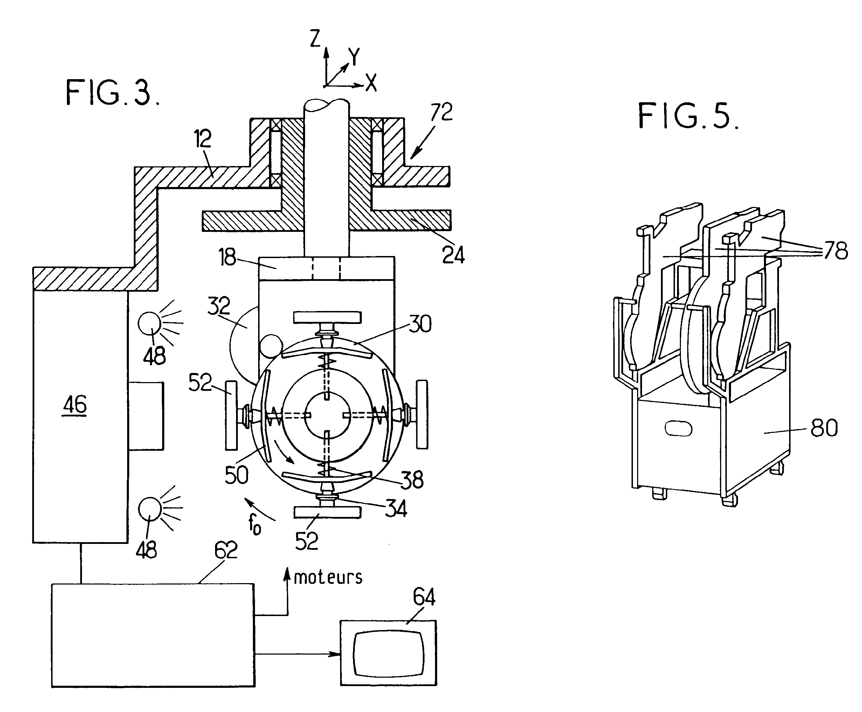

La tête 72 montrée en figures 2 et 3 comporte une embase 12 munie de patins (non représentés) de guidage sur la voie de circulation du bâti 70 de la machine entre les emplacements de saisie de composants et un emplacement de pose sur un circuit imprimé 60 immobilisé sur la table 58. Les moyens de déplacement de la tête d'un emplacement à l'autre, peuvent être constitués par un moteur électrique 16 porté par le bâti et dont l'arbre de sortie entraîne un train d'engrenages 14a, 14b dont le pignon de sortie 14b attaque une vis-mère 15, fixe en translation et en rotation.

Sur l'embase 12 est montée une équerre 18 dont la position le long d'un axe vertical et l'orientation autour de cet axe (direction Z) sont modifiables. Pour cela, à l'équerre 18 est fixé un arbre 20 muni d'une crémaillère 22 engrenant un pignon porté par l'arbre de sortie d'un moteur électrique d'entraînement 23 qui permet donc de déplacer l'équerre suivant la direction Z. L'arbre est claveté coulissant dans une couronne dentée 24 engrenant un pignon 26 porté par l'arbre de sortie d'un moteur 28 d'ajustage de la position angulaire autour de la direction Z, dans une plage qui peut être étroite.

L'équerre 18 porte un palier 29 d'axe orthogonal à Z. Le moteur 28 permet d'ajuster l'orientation, (qui reste toutefois sensiblement toujours proche d'une direction Y orthogonale à la direction X) de ce palier. Une tourelle 30 portée par le palier est entraînée en rotation autour de l'axe du palier par un moteur électrique 32 et une liaison pignon-couronne similaire à celle qui entraîne l'arbre 20.

La tourelle 30 porte plusieurs buses de saisie de composants, réparties à intervalles angulaires égaux, au nombre de quatre dans le mode de réalisation représenté. Chacune des buses 34 est montée sur la tourelle 30 de façon à pouvoir coulisser radialement. Pour cela, elle est prolongée par une tige 36 qui coulisse radialement dans la tourelle 30. Un ressort 38 repousse radialement la buse vers l'extérieur, c'est-à-dire vers une position de saillie maximum, fixée par l'appui d'une butée 40 portée par la tige contre la tourelle. Chaque buse 34 est reliée, par un tuyau souple 42, à une électrovanne d'alimentation en vide particulière (non représentée) portée par l'équerre et raccordée à une source de dépression. Les tuyaux 42 passent avantageusement le long de l'axe d'une partie tubulaire de l'équerre 18, portant le palier 29, et le long de l'axe de l'arbre 20. A chaque buse 34 est associé un contact de fin de course 44 qui se ferme dès que le ressort de rappel 38 fléchit et que la butée 40 se soulève.

Les moteurs électriques d'entrainement peuvent être à commande pas-à-pas, permettant de déterminer leurs déplacements par rapport à une origine, ou être associés à des capteurs de position ou de déplacement, permettant de communiquer à tout moment, à un calculateur central 62 équipant la machine, la position de la tête suivant la direction X, la hauteur de la tourelle suivant la direction Z et l'orientation de la tête et de la tourelle.

Des moyens de vérification optique associés à la tourelle et portés par la tête comprennent, dans le mode de réalisation illustré, une caméra vidéo 46 et des moyens d'éclairement 48. La caméra vidéo est placée de façon à être alignée avec une buse lorsqu'une autre buse 34 est dans l'orientation verticale, pour laquelle elle peut saisir ou poser un composant. Derrière chaque buse est avantageusement placé un écran 50 de teinte uniforme, d'encombrement en plan supérieur à celui du plus grand des composants 52 à saisir, permettant une vision nette des contours du composant.

Dans un mode avantageux de réalisation l'image fournie par la caméra 46 est appliquée à un système d'analyse, généralement intégré au calculateur central 62 de la machine (Figure 3). L'analyse de l'image permet de vérifier que la forme du composant visualisé est bien celle du composant qui est effectivement à poser, d'après le programme enregistré en machine. Il est également possible de déceler tout écart de la position du composant sur la buse par rapport à la position qu'il devrait normalement avoir pour permettre la pose et de corriger en conséquence les déplacements de la tête ou d'une table portant le substrat qui doit recevoir le composant. Le composant peut également être visualisé sur un écran 64.

Les têtes 72a ou 72b et les magasins 78 sont avantageusement munis de moyens permettant de repérer la présence d'un magasin et de localiser de façon précise ce magasin le long de la direction longitudinale X. Ces moyens peuvent par exemple être ceux décrits dans la demande de brevet français n° 90 05075. Il suffit de relever ici que chaque magasin contient des moyens de mémorisation contenant des données d'identification de la nature du chargeur, d'identification des composants qu'il contient, et éventuellement des données concernant d'autres paramètres de fonctionnement et que le contenu de ces moyens de mémorisation peut être transféré au calculateur central de la machine en réponse à une interrogation.

Le magasin ou plusieurs magasins peuvent être portés par un chariot permettant d'amener le chargeur contre la machine, de le retirer et de le remplacer par un autre. La figure 5 montre, de façon schématique, trois magasins 78 portés par un même chariot de transport 80, prévus pour que tous les emplacements de saisie par la tête 72 se trouvent au même niveau et à la même distance d'un axe longitudinal de la machine, même dans le cas de chargeurs qui diffèrent par leur encombrement ou par leur développement le long de la direction X. Le chariot 44 peut être muni de roues pour faciliter son approche et son enlèvement.

On verra que la machine n'impose pas de donner aux magasins une position bien déterminée dans la direction X. Il n'est en conséquence pas nécessaire de placer les magasins 78 sur leur chariot 80 dans une position bien déterminée et il n'est pas non plus nécessaire de munir le chariot de moyens d'alignement avec la machine dans une position bien déterminée.

La machine qui vient d'être décrite permet de mettre en oeuvre un procédé comportant les étapes décrites ci-après, dont le séquencement est piloté par le calculateur central 32.

Une carte nue ou partiellement équipée 60 est amenée par le convoyeur 74 sur la table 60, alors que cette dernière est libre et a été avancée, par rapport à la position où elle est montrée en figure 1, de façon à se trouver entre les convoyeurs 74 et 76. Chaque tête 72a ou 72b est alors actionnée pour saisir plusieurs composants. La tête 72a par exemple est déplacée suivant la direction X pour amener la tourelle 30 au-dessus de l'emplacement de saisie d'un composant à mettre en place. Celle des buses 34 qui est dirigée vers le bas est mise en dépression. Le moteur 23 est actionné pour descendre la tourelle jusqu'à ce que la fermeture du contact fin de course 44 indique que la buse 34 correspondante est appliquée sur un composant. La tourelle est alors remontée. Le moteur 32 est actionné pour la faire tourner de 90° dans le sens indiqué par la flèche f₀, afin d'amener le composant saisi en face de la caméra 46. La caméra fournit une image qui est analysée. L'analyse permet de vérifier qu'un composant est présent et que sa position et son orientation sont convenable.

Pendant l'analyse de l'image, la tête est déplacée suivant la direction X, puis actionnée pour saisir un second composant à l'aide d'une nouvelle buse, et ainsi de suite jusqu'à ce que la tourelle ait saisi quatre composants.

La tête 72a est ensuite déplacée, suivant la direction X, tandis que la table 58 est déplacée de façon que le composant porté par la buse orientée vers le bas se trouve face à son emplacement de pose.

La tourelle est alors descendue par le moteur 23 jusqu'à ce que le contact 44 se ferme. Le signal est transmis au calculateur 62 qui actionne une électro-vanne d'alimentation du tuyau 44 pour relacher le composant.

Dans le cas où la machine comporte deux têtes 72a et 72b, les têtes exécutent le même cycle, mais avec un décalage : pendant que l'une des têtes pose les composants, l'autre saisit des composants.

Dans le cas fréquent où le substrat doit être préencollé, la pose d'un composant est précédée par le dépôt d'une goutte de colle par l'unité 82. Les têtes 72a et 72b peuvent être prévues pour se solidariser de l'unité 82 de façon à commander les déplacements de l'unité ou des unités de pré-encollage.

On voit que la disposition qui vient d'être décrite permet à l'opérateur 84 d'intervenir sans difficulté pour remplacer des magasins ou des chariots et/ou intervenir en cas d'incident.

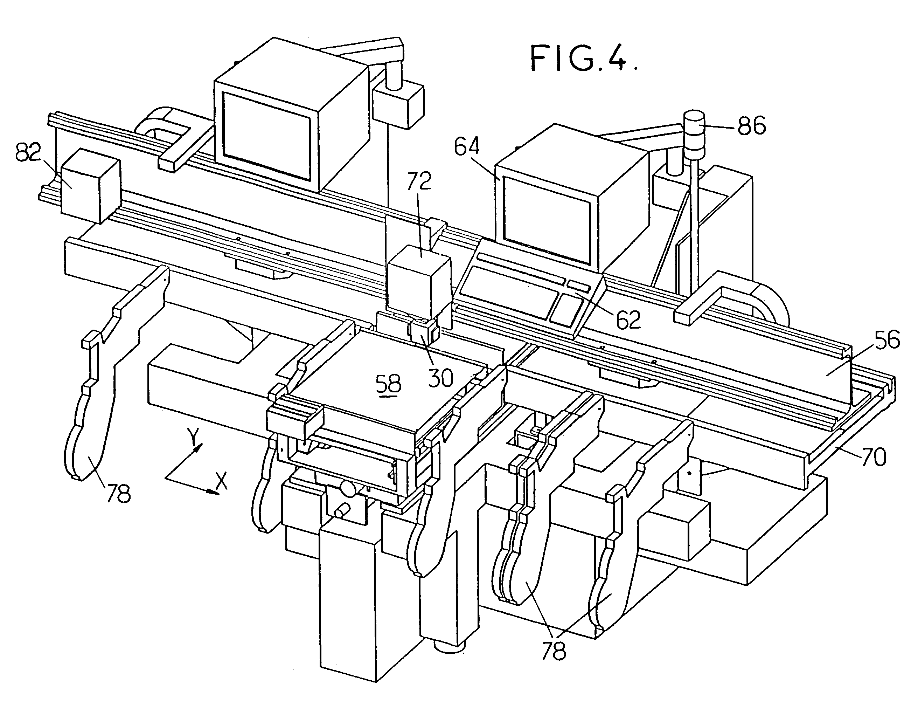

La disposition matérielle des composants de la machine peut être celle schématisée sur la figure 4. Les magasins 78 (dont les chariots ne sont pas représentés) viennent porter contre le bâti 70. La tête 72 est déplaçable sur une glissière longitudinale 56, le long d'un trajet qui amène la tourelle 30 successivement au-dessus des emplacements de prise et au-dessus de la table 58 déplaçable suivant la direction Y, les indications nécessaires au fonctionnement de la machine, notamment la nature des composants à implanter et les emplacements sur lesquels ils doivent être insérés sur une carte de circuits imprimés peuvent être introduites dans le calculateur central 62 au moyen d'un clavier ou d'un lecteur de support de logiciel, non représenté. Plusieurs écrans 64 peuvent être prévus. Une signalisation d'alarme 86, destinée à alerter un opérateur en cas de défaut de fonctionnement, de nature lumineuse ou sonore, peut être implantée sur un mât afin d'être visible depuis n'importe quel point d'un atelier.

## Revendications

1. Machine de montage automatique de composants électroniques sur un substrat, caractérisée en ce qu'elle comprend, en combinaison un convoyeur (74) d'approvisionnement en substrats (60) successifs suivant une direction longitudinale X vers un emplacement accessible par une table (58) munie de moyens permettant de la déplacer transversalement suivant une direction Y, un convoyeur (76) d'évacuation de substrats suivant la direction longitudinale X à partir de la table (58), au moins une tête (72a,72b) déplaçable dans le direction longitudinale pour venir se placer face à des magasins (78) d'approvisionnement en composants répartis dans la direction longitudinale X du bâti, d'un seul côté de ce dernier, et munie de moyens d'identification des composants et de moyens permettant de prélever un composant (52) à la fois et de le poser sur le substrat (60), et des moyens (62) de calcul et de commande des déplacements des convoyeurs, de la table et de la tête suivant un programme pré-enregistré.

2. Machine selon la revendication 1, caractérisée en ce qu'elle comporte deux têtes (72a,72b) à fonctionnement indépendant.

3. Machine selon la revendication 1 ou 2, caractérisée en ce qu'elle comporte des moyens (82) de pré-encollage du substrat aux emplacements destinés à recevoir les composants, ayant une unité d'encollage portant un micro-doseur et déplaçable entre une position d'attente et une position située au-dessus de la table.

4. Machine selon la revendication 3, caractérisée en ce que l'unité d'encollage (82) est accouplable à la tête de prélèvement et de pose.

5. Machine selon l'une quelconque des revendications précédentes, caractérisée en ce que la tête comprend : une tourelle (30) déplaçable entre au moins un emplacement de saisie et un emplacement de pose, portant plusieurs buses (34) de saisie de composant et de pose sur le substrat, réparties angulairement autour d'un axe horizontal de rotation de la tourelle ; des moyens de vérification optique (46) ; et des moyens moteurs (32) d'entraînement en rotation de la tourelle permettant d'amener chaque buse (34) à son tour dans une orientation de saisie et de pose, alors qu'un autre composant est dans une orientation de contrôle, lesdits moyens de vérification optique comportant une caméra vidéo (46) reliée à des moyens d'analyse de l'image fournie par la caméra, permettant de détecter l'existence, et éventuellement l'amplitude et la direction, d'un écart de chaque composant à son tour par rapport à sa position nominale sur la buse (34) et l'absence d'anomalie du composant pendant que ce composant est dans une orientation de contrôle alors qu'un autre composant est en cours de saisie ou que la tourelle se déplace vers l'emplacement de pose, chacune des buses (34) étant entourée d'un écran (50) de teinte uniforme et de dimension en plan supérieure à la dimension maximale des composants à saisir, placé derrière le composant dans le champ de vision de la caméra.

6. Procédé de montage automatique de composants sur des substrats successifs, suivant lequel on amène chaque substrat à son tour sur une table de déplacement suivant une direction Y, on dépose une quantité dosée de colle à l'emplacement ou chaque emplacement destiné à recevoir un composant et on place ce dernier à l'aide d'une tête de prélèvement, de déplacement suivant une direction longitudinale X orthogonale à Y, et de dépose, de manière qu'on identifie chaque magasin au passage de la tête devant lui, on prélève le composant approprié dans le magasin identifié comme le contenant à l'aide de la tête, on déplace la tête uniquement suivant ladite direction orthogonale X jusqu'à l'emplacement en X qui doit recevoir le composant, on déplace la table suivant Y jusqu'à ce que l'emplacement soit sous la tête et on pose le composant, toutes les opérations étant commandées en séquence par un programme pré-enregistré.

7. Procédé selon la revendication 6, mettant en oeuvre deux têtes à déplacement colinéaire, caractérisé en ce que chaque tête est actionnée par le programme de façon que chaque tête de préhension soit autonome vis-à-vis de l'autre tête et comprenne ses moyens de déplacement, de repérage de magasin à composants, de préhension et d'identification des composants et de constat de la pose de ceux-ci.

8. Procédé selon la revendication 7, caractérisé en ce que le programme est prévu pour que, si un composant normalement affecté à la zone de préhension d'une première tête est situé dans la zone de préhension d'une deuxième tête, le cycle des opérations continue, le composant étant recherché, identifié et mis en place par la deuxième tête.

9. Procédé selon la revendication 6, 7 ou 8, caractérisé en ce que le programme est prévu pour que, après recherche et identification des magasins et détermination des coordonnées exactes de préhension des composants suivant un plan horizontal, ainsi que des coordonnées exactes suivant le plan horizontal et de l'altitude du point de pose des composants, les différentes coordonnées soient mémorisées.

10. Procédé selon la revendication 9, caractérisé en ce que les coordonnées sont corrigées d'un signal d'erreur délivré par les moyens d'identification du composant en fonction de la position réelle des composants sur la tête de préhension.

## Patentansprüche

1. Vorrichtung zum automatischen Anbringen elektronischer Bauteile auf einem Substrat, dadurch gekennzeichnet, daß sie in Kombination umfaßt eine Transporteinrichtung (74) zum Zuführen aufeinanderfolgender Substrate (60) in einer Längsrichtung X zu einer für einen Tisch (58) zugänglichen Stelle, welcher seine Transversalverlagerung in einer Richtung Y ermöglichende Mittel aufweist, eine Transporteinrichtung (76) zum Entfernen von Substraten in der Längsrichtung X von dem Tisch (58) ab, wenigstens einen Kopf (72a, 72b), welcher in der Längsrichtung verlagerbar ist, um zu in der Längsrichtung X des Rahmens an einer einzigen Seite des letzteren verteilten Bauteilzuführspeichern (78) hin plaziert zu werden, und Mittel zur Identifikation der Bauteile sowie Mittel aufweist, welche es ermöglichen, ein Bauteil (52) auf einmal zu entnehmen und es auf dem Substrat (60) anzuordnen, und Mittel (62) zur Berechnung und zur Steuerung der Verlagerungen der Transporteinrichtungen, des Tisches und des Kopfs gemäß einem voraufgezeichneten Programm.

2. Vorrichtung nach Anspruch 1, dadurch gekennzeichnet, daß sie zwei unabhängig betreibbare Köpfe (72a, 72b) umfaßt.

3. Vorrichtung nach Anspruch 1 oder 2, dadurch gekennzeichnet, daß sie eine Klebeeinheit aufweisende Mittel (82) zur Vor-Anbringung von Klebstoff auf dem Substrat an den zum Aufnehmen der Bauteile bestimmten Stellen umfaßt, wobei die Klebeeinheit eine Mikrodosiereinrichtung aufweist und zwischen einer Warteposition und einer Position oberhalb des Tisches verlagerbar ist.

4. Vorrichtung nach Anspruch 3, dadurch gekennzeichnet, daß die Klebeeinheit (82) mit dem Entnahme- und Anordenkopf koppelbar ist.

5. Vorrichtung nach einem der vorhergehenden Ansprüche, dadurch gekennzeichnet, daß der Kopf umfaßt: einen zwischen wenigstens einer Greifstelle und einer Anordenstelle verlagerbaren Drehkopf (30), welcher mehrere um eine horizontale Drehachse des Drehkopfs winkelmäßig verteilte Düsen (34) zum Greifen der Bauteile und zum Anordnen auf dem Substrat aufweist; optische Prüfmittel (46); und Motormittel (32) zum Antreiben des Drehkopfs zur Drehung, wodurch nacheinander jede Düse (34) in eine Lage zum Greifen und zum Anordnen bringbar ist, während ein anderes Bauteil in einer Lage zum Überprüfen ist, wobei die optischen Prüfmittel eine Videokamera (46) umfassen, welche mit Mitteln zur Analyse des von der Kamera gelieferten Bilds verbunden ist, wodurch die Existenz und gegebenenfalls die Größe und die Richtung einer Abweichung jedes Bauteils nacheinander im Vergleich zu seiner Sollstellung auf der Düse (34) und die Abwesenheit von Anomalien des Bauteils erfaßbar ist, wenn dieses Bauteil in einer Lage zum Überprüfen ist, während ein anderes Bauteil ergriffen wird oder der Drehkopf sich zur Anordenstelle verlagert, wobei jede der Düsen (34) von einem gleichmäßig getönten Schirm (50) umgeben ist, dessen ebene Abmessung größer ist als die Maximalabmessung der zu greifenden Bauteile und der hinter dem Bauteil in dem Sichtfeld der Kamera angeordnet ist.

6. Verfahren zum automatischen Anbringen von Bauteilen auf aufeinanderfolgenden Substraten, gemäß welchem nacheinander jedes Substrat auf einen in einer Richtung Y verlagerbaren Tisch gebracht wird, eine dosierte Menge Klebstoff auf die Stelle oder jede Stelle abgelagert wird, welche zur Aufnahme eines Bauteils bestimmt ist, und letzteres mit Hilfe eines in einer zur Richtung Y orthogonalen Längsrichtung X verlagerbaren Entnahme- und Ablagekopfs plaziert wird, in der Weise, daß jeder Speicher beim Vorbeigang des Kopfs vor diesem identifiziert wird, das geeignete Bauteil aus dem als dieses enthaltend identifizierten Speicher mit Hilfe des Kopfs entnommen wird, der Kopf nur in der Orthogonalrichtung X verlagert wird, bis zu der Stelle bezüglich X, welche das Bauteil aufnehmen muß, der Tisch entlang Y verlagert wird bis die Stelle unter dem Kopf ist und das Bauteil angeordnet wird, wobei jeder Arbeitsgang in Aufeinanderfolge von einem vor-aufgezeichneten Programm gesteuert wird.

7. Verfahren nach Anspruch 6, bei welchem zwei kolinear verlagerbare Köpfe benutzt werden, dadurch gekennzeichnet, daß jeder Kopf von dem Programm derart betrieben wird, daß jeder Greifkopf gegenüber dem anderen Kopf autonom ist und seine Mittel zur Verlagerung, Bauteilspeicherortung, zum Greifen und zur Identifikation der Bauteile und zur Feststellung des Anordnens desselben umfaßt.

8. Verfahren nach Anspruch 7, dadurch gekennzeichnet, daß das Programm dazu vorgesehen ist, daß dann, wenn ein normalerweise für den Greifbereich eines ersten Kopfs bestimmtes Bauteil sich in dem Greifbereich eines zweiten Kopfs befindet, der Bearbeitungszyklus fortfährt, wobei das Bauteil von dem zweiten Kopf gesucht, identifiziert und plaziert wird.

9. Verfahren nach Anspruch 6, 7 oder 8, dadurch gekennzeichnet, daß das Programm dazu vorgesehen ist, daß nach Suche und Identifikation der Speicher und Bestimmung der exakten Koordinaten des Greifens der Bauteile in einer Horizontalebene sowie der exakten Koordinaten in der Horizontalebene und der Höhe des Anordenorts der Bauteile die unterschiedlichen Koordinaten gespeichert werden.

10. Verfahren nach Anspruch 9, dadurch gekennzeichnet, daß die Koordinaten durch ein Fehlersignal korrigiert werden, welches von den Bauteilidentifikationsmitteln als Funktion der wirklichen Stellung der Bauteile auf dem Greifkopf geliefert wird.

## Claims

1. A machine for automatically placing electronic components on a substrate, characterized in that it comprises, in combination a conveyor (74) for feeding successive substrates (60) along a longitudinal direction X towards a position accessible by a table (58) having means for moving it transversely along a direction Y, a conveyor (76) for removing substrates in the longitudinal direction X from the table (58), at least one head (72a,72b) movable in the longitudinal direction X to position in front of component feed magazines (78) distributed in the longitudinal direction X of the frame, only on one side thereof, having means for identifying the components and means for picking one component (52) at a time and placing it on the substrate (60), and means (62) for computing and controlling the movements of the conveyors, of the table and of the head in accordance with a prerecorded program.

2. Machine according to claim 1, characterized in that it has two independently actuated heads (72a,72b).

3. Machine according to claim 1 or 2, characterized in that it comprises means (82) for precoating a substrate with adhesive at locations for receiving the components, having a precoating unit carrying a micro-dispenser and movable between a stand-by position and a position situated above the table.

4. Machine according to claim 3, characterized in that the precoating unit (82) is arranged to be coupled to the pick-up and locating head.

5. Machine according to any one of the preceding claims, characterized in that the head comprises: a turret (30) movable between at least a pick-up position and a placement position, carrying a plurality of nozzles (34) for picking up components and locating them on the substrate, angularly distributed about an horizontal rotation axis of the turret; optical checking means (46); and motor means (32) for rotating the turret and moving each nozzle (34) in turn to an angular position for pick-up and placement of a component while another component is in a checking angular position, said optical checking means having a video camera (46) connected to means for analysing the image delivered by said camera, adapted to detect the existence, and possibly the amount and direction, of a deviation of each component in turn with respect to its set position on the nozzle (34) and the absence of an anomaly of the component while the component is in a checking orientation or the turret moves toward the placement location, each of the nozzles (34) being surrounded with a screen (50) of uniform colour, having a surface exceeding the maximum size of the components to be picked up, located behind the component in the field of view of the camera.

6. A process for automatically placing components on successive substrates comprising the steps of: bringing each substrate in turn onto a table movable in a direction Y, depositing a metered amount of adhesive at the or each location for receiving a component and placing the latter by means of a head for pick-up, movement in a longitudinal direction X orthogonal to Y, and placement, wherein each magazine is identified when the head passes in front of it, the appropriate component is picked up from the magazine identified by the head as containing it, only moving the head in said orthogonal direction X as far as the location along X which is to receive the component, moving the table along Y until the location is under the head and laying the component, all operations being controlled in sequence by a prerecorded program.

7. A process according to claim 6, using two heads movable along a common direction, characterized in that each head is so controlled by the program that each pick-up head is autonomous with respect to the other head and has its own means for movement, detection of a component magazine, pick-up and identification of the components and confirmation of the placement of the latter.

8. A process according to claim 7, characterized in that the program is arranged for the sequence of operations to proceed if a component which is normally assigned to the pick-up zone of a first head is located in the pick-up zone of the second head, the component being then searched, identified and placed by the second head.

9. A process according to claim 6, 7 or 8, characterized in that the program is arranged for storing the different coordinates after search and identification of the magazines and determination of the accurate coordinates where the components are picked up in a horizontal plane, as well as the accurate coordinates in the horizontal plane and the altitude of the placement points of the components.

10. A process according to claim 9, characterized in that the coordinates are adjusted responsive to an error signal delivered by the component identification means responsive to the actual position of the components on the pick-up head.
